# EUROPEAN PATENT APPLICATION

(11) **EP 3 355 433 A1**
(43) Date of publication of application: **01.08.2018**
(21) Application number: 16847782.6
(22) Date of filing: 21.04.2016
(51) Int. Cl.: H02H 7/20

(54) **IGBT SHORT-CIRCUIT DETECTION AND PROTECTION CIRCUIT AND IGBT-BASED CONTROLLABLE RECTIFIER CIRCUIT**

(30) Priority: 25.09.2015 CN 201520755608 U
(71) Applicant: Johnson Controls Technology Company, Milwaukee, WI 53209 (US); Johnson Controls Air Conditioning And Refrigeration Company (Wuxi) Co., Ltd, Wuxi, Jiangsu 214000 (CN); York (Wuxi) Air Conditioning And Refrigeration Co., Ltd., Wuxi, Jiangsu 214028 (CN)
(72) Inventor: MIAO, Yu, Wuxi Jiangsu 214028 (CN); XIE, Yongquan, Wuxi Jiangsu 214028 (CN); LI, Chengzhi, Wuxi Jiangsu 214028 (CN); SHAO, Guobin, Wuxi Jiangsu 214028 (CN)
(74) Representative: Trinks, Ole
(86) International application number: PCT/CN2016/079835
(87) International publication number: WO 2017/049900

(57) **Abstract**

An IGBT short-circuit detection and protection circuit, comprising: a driving unit, the output end thereof outputting a PWM driving signal and being connected to gate ends of a first IGBT (IGBT1) and a second IGBT (IGBT2), so as to simultaneously control the turning ON/OFF of the first IGBT and the second IGBT; a comparing unit, comprising a threshold pin and a detection pin (Vdesat), the threshold pin being connected to a threshold voltage, the detection pin being connected by means of a first diode (D1) and a second diode (D3) to collectors (C) of the first IGBT and the second IGBT, respectively, the detection pin supplying a detection current to the first diode and the second diode, cathodes of the first diode and the second diode being connected to the collectors of the first IGBT and the second IGBT, respectively; when the voltage at the detection pin is higher than the threshold voltage, the driving unit controlling the first IGBT and the second IGBT to be turned off. The IGBT short-circuit detection protection circuit achieves bidirectional short-circuit protection of two IGBTs in inverse series connection, without requiring an additional protection circuit.

## Description

### TECHNICAL FIELD

The present invention relates to an IGBT-based controllable rectifier circuit and a protection circuit, and specifically relates to an IGBT short-circuit detection and protection circuit and an IGBT-based controllable rectifier circuit.

### BACKGROUND ART

As an electronic switch, an IGBT is in the vast majority of cases used for switching DC voltage (realizing DC chopping). Thus, when an IGBT experiences a short circuit, current flowing through the IGBT is always in a fixed direction, so it is only necessary to design a corresponding short-circuit protection circuit according to this current direction. On the other hand, when an IGBT is used as an AC electronic switch, if the IGBT experiences a short circuit then the direction of current in the IGBT is determined by the voltage polarity across the IGBT, i.e. the direction of current is indeterminate when the IGBT is short-circuited. In order to protect the IGBT comprehensively, separate short-circuit protection is needed for each of the two directions. A common IGBT short-circuit protection method is to detect a voltage drop Vce between the collector and emitter of the IGBT, feed it into a non-inverting input terminal of a comparator in a drive optocoupler, and perform a comparison with a fixed valve value of an inverting input terminal. The principle thereof is that a rapid increase in Ic is followed by an increase in Vce, according to a relationship between Vce and Ic, wherein Vce is the voltage drop between the collector and emitter, and Ic is current between the collector and emitter. Thus, when Vce is greater than the fixed valve value of the inverting terminal, this indicates that the IGBT is experiencing a short circuit, at which time the comparator flips to realize short-circuit protection. However, the method can only realize short-circuit protection in a fixed current direction; if it is desired to realize short-circuit protection in two directions, then it is necessary to add an extra short-circuit protection circuit for the other direction, and the corresponding cost is increased considerably.

Thus, in the order to solve the abovementioned technical problem, there is a need to propose an improved IGBT bidirectional short-circuit detection and protection circuit.

### CONTENT OF THE INVENTION

In response to the shortcomings of the prior art, the present invention proposes an improved IGBT bidirectional short-circuit detection and protection circuit, which is capable of realizing bidirectional short-circuit protection of two reverse-series-connected IGBTs, with no need to add an extra short-circuit protection circuit.

An embodiment of the present invention provides an IGBT short-circuit detection and protection circuit, for IGBT short-circuit detection and protection, the circuit comprising: a drive unit, for generating a PWM drive signal to control switching on of the IGBT; a comparison unit, having a threshold pin and a detection pin, the threshold pin being connected to a threshold voltage, the detection pin being connected to a collector of the IGBT via a diode, the detection pin supplying a detection current for the diode, and a cathode of the diode being connected to the collector of the IGBT, wherein when a voltage at the detection pin is greater than the threshold voltage, the drive unit controls the IGBT so that same switches off.

Furthermore, an emitter of the IGBT is connected to a reference ground voltage.

Furthermore, the drive unit and the comparison unit are integrated in a single chip.

Another embodiment of the present invention provides an IGBT short-circuit detection and protection circuit, for subjecting a pair of reverse-series-connected IGBTs to short-circuit detection and protection, the pair of IGBTs comprising a first IGBT and a second IGBT, and an emitter of the first IGBT being connected to an emitter of the second IGBT, the circuit comprising: a drive unit, an output terminal thereof outputting a PWM drive signal, and being connected to gate terminals of the first IGBT and the second IGBT, to simultaneously control switching on of the first IGBT and the second IGBT; a comparison unit, having a threshold pin and a detection pin, the threshold pin being connected to a threshold voltage, the detection pin being connected to collectors of the first IGBT and the second IGBT via a first diode and a second diode respectively, the detection pin supplying a detection current for the first diode and the second diode, and cathodes of the first diode and the second diode being connected to the collectors of the first IGBT and the second IGBT respectively, wherein when a voltage at the detection pin is greater than the threshold voltage, the drive unit controls the first IGBT and the second IGBT so that same switch off.

Furthermore, a first flyback diode and a second flyback diode are reverse-parallel-connected between the collector and emitter of the first IGBT and the second IGBT respectively.

Furthermore, the drive unit and the comparison unit are integrated in a single chip.

Another embodiment of the present invention provides an IGBT-based controllable rectifier circuit, comprising: a three-phase AC power supply and three reverse-series-connected IGBT units, wherein each reverse-series-connected IGBT unit comprises a first IGBT and a second IGBT, an emitter of the first IGBT is connected to an emitter of the second IGBT, a collector of one of the first IGBT and the second IGBT is connected to one phase of the three-phase AC power supply, and a collector of the other one of the first IGBT and the second IGBT is connected to a collector of one of the other two IGBT units, wherein each IGBT unit further comprises: a drive unit, an output terminal thereof outputting a PWM drive signal, and being connected to gate terminals of the first IGBT and the second IGBT, to simultaneously control switching on of the first IGBT and the second IGBT; a comparison unit, having a threshold pin and a detection pin, the threshold pin being connected to a threshold voltage, the detection pin being connected to the collectors of the first IGBT and the second IGBT via a first diode and a second diode respectively, the detection pin supplying a detection current for the first diode and the second diode, and cathodes of the first diode and the second diode being connected to the collectors of the first IGBT and the second IGBT respectively, wherein when a voltage at the detection pin is greater than the threshold voltage, the drive unit controls the first IGBT and the second IGBT so that same switch off.

Furthermore, a first flyback diode and a second flyback diode are reverse-parallel-connected between the collector and emitter of the first IGBT and the second IGBT respectively.

Furthermore, each phase of the three-phase AC power supply is connected to one of the IGBT units via an inductance.

Furthermore, the drive unit and the comparison unit are integrated in a single chip.

The IGBT short-circuit detection and protection circuit of the present invention makes use of the characteristic that if a short circuit occurs when the IGBT is conducting, then the current direction is determined by the polarity of voltage across it, and realizes bidirectional short-circuit protection of two reverse-series-connected IGBTs by merely adding a diode for each IGBT, with no need to add an extra short-circuit protection circuit.

Furthermore, the present invention makes use of a drive chip containing a comparator, simultaneously realizing a bidirectional short-circuit protection function for two reverse-series-connected IGBTs; the bidirectional short-circuit protection functions are both triggered by hardware, realizing soft turn-off, thereby simplifying the circuit while greatly reducing costs, and increasing the circuit stability.

### DESCRIPTION OF THE ACCOMPANYING DRAWINGS

The purpose of the accompanying drawings of the present invention set out below, which form part of the present invention, is to enable understanding of the present invention. Embodiments of the present invention and descriptions thereof are shown in the accompanying drawings, for the purpose of explaining the principles of the present invention.

In the drawings:
- Fig. 1: shows a schematic circuit diagram of an IGBT short-circuit detection and protection circuit according to an embodiment of the present invention.
- Fig. 2: shows a schematic circuit diagram of a short-circuit detection and protection circuit for a pair of reverse-series-connected IGBTs according to an embodiment of the present invention.
- Fig. 3: shows a schematic circuit diagram of an IGBT-based controllable rectifier circuit according to an embodiment of the present invention.
- Fig. 4: is intended to explain the principles of IGBT short-circuit detection and protection in a first current direction in the controllable rectifier circuit shown in fig. 3.
- Fig. 5: is intended to explain the principles of IGBT short-circuit detection and protection in a second current direction in the controllable rectifier circuit shown in fig. 3.
- Fig. 6: shows a schematic circuit diagram of an IGBT-based rectifier circuit according to another embodiment of the present invention.

### PARTICULAR EMBODIMENTS

In the following description, a large number of specific details are given in order to provide a more thorough understanding of the present invention. However, it will be obvious to those skilled in the art that the present invention could be implemented in the absence of one or more of these details. In other examples, certain technical features known in the art have not been described, in order to avoid confusion with the present invention.

It should be understood that the present invention can be implemented in different forms, and should not be interpreted as being limited to the embodiments set out here. Conversely, the provision of these embodiments will make the disclosure thorough and complete, and fully transmit the scope of the present invention to those skilled in the art. Identical reference labels shall represent identical elements throughout.

In order to enable thorough understanding of the present invention, detailed steps and detailed structures will be set out in the following description to explain the technical solution of the present invention. Preferred embodiments of the present invention are described in detail below, but the present invention may also be implemented in other ways, besides these detailed descriptions.

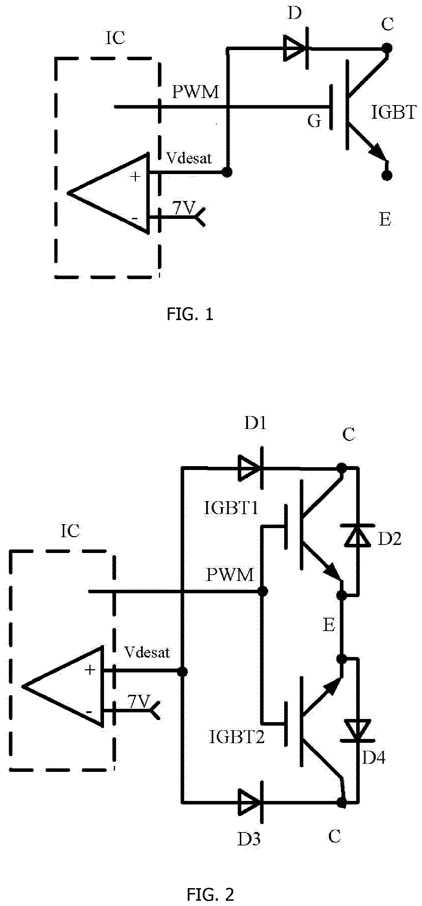

Based on the abovementioned principle that a rapid increase in Ic is followed by an increase in Vce according to the relationship between Vce and Ic, the present invention provides an IGBT short-circuit detection and protection circuit, for IGBT short-circuit detection and protection. As fig. 1 shows, the circuit comprises a drive chip IC containing a comparator; the drive chip can output a PWM drive signal to control the switching of the IGBT on and off, i.e. when the PWM drive signal is HIGH, the IGBT is switched on, and when the PWM drive signal is LOW, the IGBT is switched off. The comparator in the drive chip IC has a threshold pin and a detection pin Vdesat. The threshold pin is an inverting input terminal, and is connected to a threshold voltage; the detection pin Vdesat is a non-inverting input terminal, and is connected to a collector C of an IGBT via a diode D. The detection pin Vdesat supplies a detection current for the diode D by means of a constant current source in the drive chip, e.g. a detection current of magnitude 250 uA. A cathode of the diode D is connected to the collector C of the IGBT, the collector C of the IGBT is connected to an input voltage, and an emitter E of the IGBT is connected to a drive signal reference ground voltage. When the IGBT is conducting, a current flows from the collector towards the emitter; at this time, the diode D is also conducting, and an input voltage of the detection pin Vdesat is the voltage drop of the diode D + the voltage drop Vce between the collector and emitter of the IGBT. If the IGBT experiences a short circuit, the current Ic between the collector and emitter increases, hence the voltage drop Vce between the collector and emitter also increases. When the voltage at the detection pin Vdesat is greater than the threshold voltage e.g. the 7V stated in fig. 1, the comparator in the drive chip flips, and the PWM drive signal outputted by the drive chip then changes to LOW, and the IGBT is switched off, realizing short-circuit protection.

On the basis of the IGBT short-circuit detection and protection circuit described above, the present invention also provides an IGBT short-circuit detection and protection circuit, for subjecting a pair of reverse-series-connected IGBTs to short-circuit detection and protection. As shown in fig. 2, the pair of IGBTs comprises a first IGBT (IGBT 1) and a second IGBT (IGBT 2). An emitter E of the first IGBT is connected to an emitter E of the second IGBT, and a collector of the first IGBT is connected to an input voltage. An output terminal of a drive chip IC containing a comparator outputs a PWM drive signal, and is connected to gate terminals of the first IGBT and the second IGBT, to simultaneously control the switching on of the first IGBT and the second IGBT. The comparator in the drive chip IC has a threshold pin and a detection pin Vdesat; the threshold pin is connected to a threshold voltage, and the detection pin Vdesat is connected to the collectors of the first IGBT and the second IGBT via a first high voltage isolating diode D1 and a second high voltage isolating diode D3 respectively. The detection pin Vdesat supplies a detection current for the first high voltage isolating diode D1 and the second high voltage isolating diode D3; cathodes of the first high voltage isolating diode D1 and the second high voltage isolating diode D3 are connected to the collectors C of the first IGBT and the second IGBT respectively.

In addition, a first flyback diode D2 and a second flyback diode D4 are reverse-parallel-connected between the collector C and emitter E of the first IGBT and the second IGBT respectively. The expression "reverse-parallel-connected" used here means that only one of the IGBT and the flyback diode can conduct.

When an input voltage of the detection pin Vdesat is greater than the threshold voltage, the PWM drive signal outputted by the drive chip IC changes to LOW, and the first IGBT and the second IGBT switch off. Specifically, when current flows in the direction IGBT1 -> flyback diode D4, a Vce voltage acquisition unit D1 for current in a first direction will acquire the voltage drop across the IGBT1 in real time, and feed it into the non-inverting input terminal Vdesat of the comparator for comparison with a valve value of the inverting input terminal, thereby realizing short-circuit protection for current in the first direction; when current flows in the direction IGBT2 -> flyback diode unit D2, a Vce voltage acquisition unit D3 for current in a second direction will acquire the voltage drop across the IGBT2 in real time, and feed it into the non-inverting input terminal Vdesat of the comparator for comparison with a valve value of the inverting input terminal, thereby realizing short-circuit protection for current in the second direction.

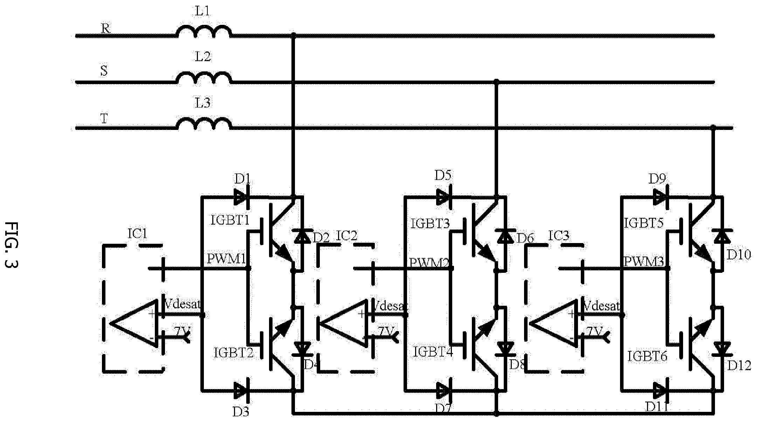

Furthermore, the abovementioned circuit of the present invention provides an IGBT-based controllable rectifier circuit; as shown in fig. 3, the rectifier circuit comprises a three-phase AC power supply having three phase inputs R, S and T, with each phase input being connected to a corresponding energy storage inductance L1/L2/L3 respectively, and each phase output being connected to a reverse-series-connected IGBT unit respectively.

As shown in fig. 3, an R phase output is connected to a first reverse-series-connected IGBT unit via the inductance L1; the first IGBT unit comprises a first IGBT (IGBT 1) and a second IGBT (IGBT 2), an emitter of the first IGBT (IGBT 1) being connected to an emitter of the second IGBT (IGBT 1), a collector of the first IGBT (IGBT 1) being connected to the R phase, and a collector of the second IGBT (IGBT 2) being connected to a collector of one of the other two IGBT units. The first IGBT unit further comprises a short-circuit detection and protection circuit; the short-circuit detection and protection circuit comprises high voltage isolating diodes and flyback diodes, and a first drive chip IC1 containing a comparator. An output terminal of the first drive chip IC1 outputs a PWM1 drive signal, and is connected to gate terminals of the first IGBT and the second IGBT, to simultaneously control the switching on of the first IGBT and the second IGBT. The comparator in the first drive chip IC1 has a threshold pin and a detection pin Vdesat; the threshold pin is connected to a threshold voltage, and the detection pin Vdesat is connected to the collectors of the first IGBT and the second IGBT via a first diode D1 and a second diode D3 respectively. The detection pin Vdesat supplies a detection current for the first diode D1 and the second diode D3; cathodes of the first diode D1 and the second diode D3 are connected to the collectors C of the first IGBT and the second IGBT respectively. A first flyback diode D2 and a second flyback diode D4 are reverse-parallel-connected between the collector C and emitter E of the first IGBT and the second IGBT respectively.

Similarly, an L phase output is connected to a second reverse-series-connected IGBT unit via the inductance L2, and a T phase output is connected to a third reverse-series-connected IGBT unit via the inductance L3. The second reverse-series-connected IGBT unit is formed of a third IGBT (IGBT 3), a fourth IGBT (IGBT 4), a third high voltage isolating diode D5, a fourth high voltage isolating diode D7, a third flyback diode D6, a fourth flyback diode D8 and a second drive chip IC2. The third reverse-series-connected IGBT unit is formed of a fifth IGBT (IGBT 5), a sixth IGBT (IGBT 5), a fifth high voltage isolating diode D9, a sixth high voltage isolating diode D11, a fifth flyback diode D10, a sixth flyback diode D12 and a third drive chip IC3. The connections of the second and third reverse-series-connected IGBT units are similar to the connections of the first reverse-series-connected IGBT unit, so are not described superfluously here.

In addition, the collectors of the second IGBT, the fourth IGBT and the sixth IGBT are connected to each other.

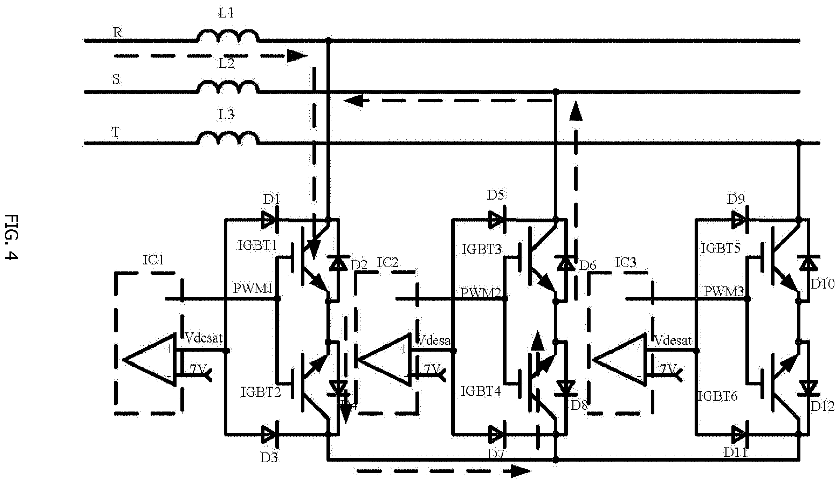

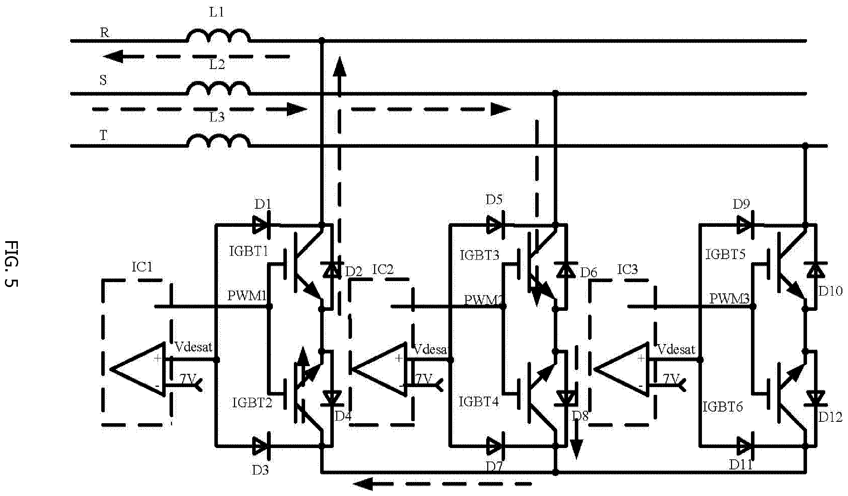

The content described above forms the IGBT-based controllable rectifier circuit of the present invention; the principle of rectification thereof is similar to that of a conventional three-switch two-level APFC circuit, so is not described superfluously here. Short-circuit detection and protection of the IGBTs in the controllable rectifier circuit in this embodiment is explained below with reference to figs. 4 and 5.

Here, a current between the R phase and the S phase is taken as an example for illustration; other inter-phase scenarios are similar. As shown in fig. 4, when PWM1 and PWM2 are both HIGH and the inter-RS voltage is in a positive half-cycle, the direction of current is R -> L1 -> IGBT1 -> D4 -> IGBT4 -> D6 -> L2 - > S (the direction indicated by the dotted-line arrow in fig. 4). Since PWM1 is HIGH, IGBT1 and IGBT2 are both in a conducting state, but according to the inter-RS voltage polarity, there is current flow through IGBT1; at this time, the diode D1 is conducting, but there is no current flow through IGBT2, and the diode D3 is cut off, therefore the voltage of the non-inverting input terminal Vdesat of the comparator in the first drive chip IC1 = the voltage across the diode D1 + the voltage drop across IGBT1. By the same principle, the diode D7 is conducting, but the diode D5 is cut off, and the non-inverting input terminal Vdesat of the comparator in the second drive chip IC2 = the voltage across the diode D7 + the voltage drop across IGBT4.

When an IGBT experiences a short circuit, the voltage drop across the IGBT increases sharply; when the voltage of the non-inverting input terminal Vdesat of the drive chip IC1/IC2 is greater than the set valve value of the inverting input terminal, the drive chip IC1/IC2 automatically carries out soft turn-off of the drive signal PWM (i.e. changes it to LOW), thereby realizing short-circuit protection for current in the direction from R -> S.

As fig. 5 shows, when PWM1 and PWM2 are both HIGH and the inter-RS voltage is in a negative half-cycle, the direction of current is S -> L2 -> IGBT3 -> D8 -> IGBT2 -> D2 -> L1 -> R (the direction indicated by the dotted-line arrow in fig. 5). Since PWM2 is HIGH, IGBT3 and IGBT4 are both in a conducting state, but according to the inter-RS voltage polarity, there is current flow through IGBT3; at this time, the diode D5 is conducting, but there is no current flow through IGBT4, and the diode D7 is cut off; the voltage of the non-inverting input terminal Vdesat of the comparator in the second drive chip IC2 = the voltage across the diode D5 + the voltage drop across the IGBT3.

By the same principle, the diode D3 is conducting, but the diode D1 is cut off, and the non-inverting input terminal Vdesat of the comparator in the first drive chip IC1 = the voltage across the diode D3 + the voltage drop across the IGBT2.

When an IGBT experiences a short circuit, the voltage drop across the IGBT increases sharply; when the voltage of the non-inverting input terminal of the drive chip IC1/IC2 is greater than the set valve value of the inverting input terminal, the drive optocoupler automatically carries out soft turn-off of the drive signal, thereby realizing short-circuit protection for current in the direction from S -> R.

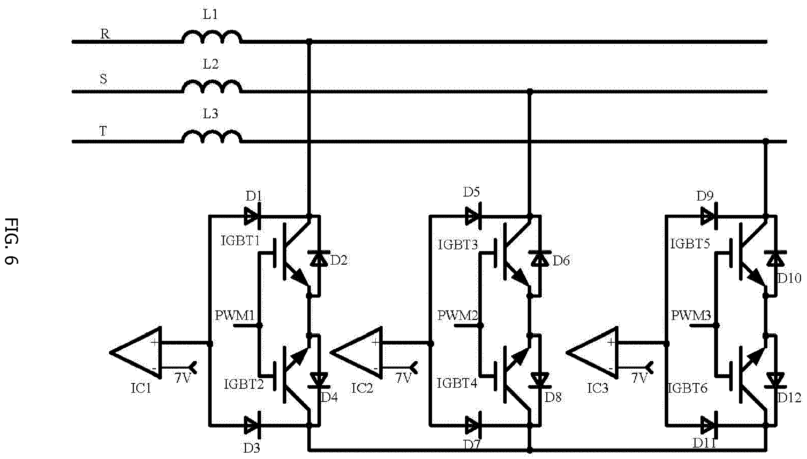

It can be understood that in the embodiment above, the comparator and the drive signal for controlling switching on of the IGBT are integrated in the drive chip IC; this enables the circuit to be simplified, to provide stability, but separate devices could also be used as required, i.e. with the IGBT drive signal and detection of the voltage between the collector and emitter being realized by means of a drive unit providing a drive signal PWM and a comparison unit respectively. This could likewise realize the abovementioned IGBT short-circuit detection and protection functions; a specific circuit is shown in fig. 6, and will be easily understood by those skilled in the art based on the description above, so is not described superfluously here.

The present invention has already been explained by means of the embodiments above, but it should be understood that the embodiments above are merely intended to serve as examples for the purpose of illustration, not to restrict the present invention to the scope of the embodiments described. Furthermore, those skilled in the art will understand that the present invention is not limited to the embodiments above. Many more types of changes in form and amendments could be made based on the teaching of the present invention, and all such changes in form and amendments shall fall within the scope of protection claimed in the present invention. The scope of protection of the present invention is defined by the attached claims and their equivalent scope.

## Claims

1. An IGBT short-circuit detection and protection circuit, for IGBT short-circuit detection and protection, **characterized in that** the circuit comprises:
- a drive unit, for generating a PWM drive signal to control switching on of the IGBT;
- a comparison unit, having a threshold pin and a detection pin, the threshold pin being connected to a threshold voltage, the detection pin being connected to a collector of the IGBT via a diode, the detection pin supplying a detection current for the diode, and a cathode of the diode being connected to the collector of the IGBT,
wherein when a voltage at the detection pin is greater than the threshold voltage, the drive unit controls the IGBT so that same switches off.

2. The IGBT short-circuit detection and protection circuit as claimed in claim 1,
**characterized in that**
an emitter of the IGBT is connected to a reference ground voltage of the drive signal.

3. The IGBT short-circuit detection and protection circuit as claimed in claim 1,
**characterized in that**
the drive unit and the comparison unit are integrated in a single chip.

4. An IGBT short-circuit detection and protection circuit, for subjecting a pair of reverse-series-connected IGBTs to short-circuit detection and protection, the pair of IGBTs comprising a first IGBT and a second IGBT, and an emitter of the first IGBT being connected to an emitter of the second IGBT, **characterized in that** the circuit comprises:
- a drive unit, an output terminal thereof outputting a PWM drive signal, and being connected to gate terminals of the first IGBT and the second IGBT, to simultaneously control switching on of the first IGBT and the second IGBT;
- a comparison unit, having a threshold pin and a detection pin, the threshold pin being connected to a threshold voltage, the detection pin being connected to collectors of the first IGBT and the second IGBT via a first diode and a second diode respectively, the detection pin supplying a detection current for the first diode and the second diode, and cathodes of the first diode and the second diode being connected to the collectors of the first IGBT and the second IGBT respectively,
wherein when a voltage at the detection pin is greater than the threshold voltage, the drive unit controls the first IGBT and the second IGBT so that same switch off.

5. The IGBT short-circuit detection and protection circuit as claimed in claim 4,
**characterized in that**
a first flyback diode and a second flyback diode are reverse-parallel-connected between the collector and emitter of the first IGBT and the second IGBT respectively.

6. The IGBT short-circuit detection and protection circuit as claimed in claim 4,
**characterized in that**
the drive unit and the comparison unit are integrated in a single chip.

7. An IGBT-based controllable rectifier circuit, **characterized by** comprising:
- a three-phase AC power supply and three reverse-series-connected IGBT units, wherein each reverse-series-connected IGBT unit comprises a first IGBT and a second IGBT, an emitter of the first IGBT is connected to an emitter of the second IGBT, a collector of one of the first IGBT and the second IGBT is connected to one phase of the three-phase AC power supply, and a collector of the other one of the first IGBT and the second IGBT is connected to a collector of one of the other two IGBT units,
wherein each IGBT unit further comprises:
- a drive unit, an output terminal thereof outputting a PWM drive signal, and being connected to gate terminals of the first IGBT and the second IGBT, to simultaneously control switching on of the first IGBT and the second IGBT;
- a comparison unit, having a threshold pin and a detection pin, the threshold pin being connected to a threshold voltage, the detection pin being connected to the collectors of the first IGBT and the second IGBT via a first diode and a second diode respectively, the detection pin supplying a detection current for the first diode and the second diode, and cathodes of the first diode and the second diode being connected to the collectors of the first IGBT and the second IGBT respectively,
wherein when a voltage at the detection pin is greater than the threshold voltage, the drive unit controls the first IGBT and the second IGBT so that same switch off.

8. The IGBT-based controllable rectifier circuit as claimed in claim 7,
**characterized in that**
a first flyback diode and a second flyback diode are reverse-parallel-connected between the collector and emitter of the first IGBT and the second IGBT respectively.

9. The IGBT-based controllable rectifier circuit as claimed in claim 7,
**characterized in that**
each phase of the three-phase AC power supply is connected to one of the IGBT units via an inductance.

10. The IGBT-based controllable rectifier circuit as claimed in claim 7,
**characterized in that**
the drive unit and the comparison unit are integrated in a single chip.
